Europäisches Patentamt

European Patent Office

Office européen des brevets

(11) Numéro de publication: **0 319 630**
**A1**

## (12) DEMANDE DE BREVET EUROPEEN

(21) Numéro de dépôt: **87402791.5**

(22) Date de dépôt: **08.12.87**

(51) Int. Cl.4: **H03K 17/97**

(43) Date de publication de la demande:
**14.06.89 Bulletin 89/24**

(84) Etats contractants désignés:
**DE GB SE**

(71) Demandeur: **Hardellet, Guy**
**La Foret-Le-Roi**
**F-91410 Dourdan(FR)**

(72) Inventeur: **Hardellet, Guy**
**La Foret-Le-Roi**
**F-91410 Dourdan(FR)**

(74) Mandataire: **Obolensky, Michel et al**
**c/o CABINET LAVOIX 2, place d'Estienne**
**d'Orves**
**F-75441 Paris Cédex 09(FR)**

(54) **Contacteur de commande, notamment pour circuits d'alimentation d'un moteur électrique d'entrainement de chariot de manutention.**

(57) Contacteur de commande notamment pour circuits d'alimentation d'un moteur électrique d'entrainement de chariot de manutention comprenant un support (10), un arbre de commande (1) monté à rotation dans les deux sens dans ledit support à l'aide de boutons de manoeuvre (11), pour commander le circuit d'alimentation du moteur électrique (7) d'entraînement du chariot de manière à déplacer le chariot soit en marche avant, soit en march arrière, ledit arbre (1) étant pourvu de moyens d'actionnement successif d'organes de commande de la modification du courant d'alimentation du moteur électrique (7) d'entraînement en fonction de la position angulaire de l'arbre, caractérisé en ce que lesdits moyens d'actionnement successif sont constitués par des aimants (3a à 3d) montés dans des supports (2a à 2d) solidaires de l'arbre de commande (1) et décalés angulairement les uns par rapport aux autres, tandis que les organes de commande de la modification du courant d'alimentation comprennent des capteurs inductifs (4a à 4d) associés aux aimants correspondants.

FIG.1

Xerox Copy Centre

## Contacteur de commande, notamment pour circuits d'alimentation d'un moteur électrique d'entraine-ment de chariot de manutention.

La présente invention est relative aux contacteurs de commande et se rapporte plus particulièrement aux contacteurs de commande pour chariots de manutention.

Les contacteurs de commande connus pour chariots de manutention sont généralement du type électromécanique, à cames décalées angulairement, montées sur un arbre et déplaçables en rotation devant des micro-interrupteurs de commande de relais de puissance faisant partie du circuit d'alimentation d'un moteur électrique d'entrainement du chariot.

On connaît également des contacteurs de commande électro-mécaniques a cames et micro-interrupteurs auxquels est associé un potentiomètre destiné à commander un variateur électronique de vitesse lorsque le chariot de manutention est équipé d'un tel variateur.

Les contacteurs de commande à micro-interrupteurs ont pour inconvénient essentiel que les contacts des micro-interrupteurs sont sujets a l'usure.

Dans les dispositifs équipés de variateurs de vitesse, les potentiomètres, qu'ils soient à piste continue ou à enroulement subissent également une usure relativement rapide.

Il en résulte que les contacteurs de commande classiques ont une durée de vie limitée et qu'il est donc nécessaire de les remplacer.

Par ailleurs, dans les contacteurs du type à potentiomètre pour variateur électronique de vitesse, il est difficile de déterminer avec précision le point zéro du potentiomètre en fonction de la position angulaire de la came associée au micro-interrupteur de commande avec l'actionnement duquel le début du déplacement du curseur du potentiomètre doit être synchro nisé.

Les potentiomètres à course morte sont chers et doivent être adaptès en angle de rotation à chaque type de matériel, ce qui accroît considérablement les coûts de montage et de mise au point.

L'invention vise à remédier aux inconénients précités des contacteurs de commande classiques et à créer, un contacteur de commande qui allie un coût de fabrication modéré à une durée de vie accrue vis à vis des contacteurs de commande de la technique antérieure.

Elle vise également à réaliser un contacteur de commande qui soit d'un réglage relativement aisé lorsqu'il comporte un système potentiométrique de commande de variateur de vitesse.

Elle a donc pour objet un contacteur de commande notamment pour circuits d'alimentation d'un moteur électrique d'entraînement de chariot de manutention comprenant un support, un arbre de commande monté à rotation dans les deux sens dans ledit support à l'aide de boutons de manoeuvre, pour commander le circuit d'alimentation du moteur électrique d'entraînement du chariot de manière a déplacer le chariot soit en marche avant, soit en marche arrière, ledit arbre étant pourvu de moyens d'actionnement successif d'organes de commande de la modification du courant d'alimentation du moteur électrique d'entraînement en fonction de la position angulaire de l'arbre, caractérisé en ce que lesdits moyens d'actionnement successif sont constitués par des aimants montés dans des supports solidaires de l'arbre de commande et décalés angulairement les uns par rapport aux autres, tandis que les organes de commande de la modification du courant d'alimentation comprennent des capteurs inductifs associés aux aimants correspondants.

L'invention sera mieux comprise à l'aide de la description qui va suivre, donnée uniquement à titre d'exemple et faite en se référant aux dessins annexés, sur lesquels :

- la Fig.1 est un schéma de principe du contacteur de commande suivant l'inventoin;

- la Fig.2 est une vue partielle en perspective éclatée d'un contacteur de commande suivant l'invention;

- la Fig.3 est une vue en plan, en arrachement partiel du contacteur de la Fig.2;

- la Fig.4 est une coupe suivant la ligne 4-4 de la Fig.3;

- la Fig.5 montre les décalages angulaires des aimants montés dans leurs supports, entrant dans la construction du contacteur de la Fig.3;

- la Fig.6 est un schéma électrique du circuit de commande dans lequel est monté un capteur inductif du contacteur suivant l'invention;

- la Fig.7 est un schéma électrique d'un variante du circuit électrique d'un capteur inductif; et

- la Fig.8 est un schéma montrant le dispositif potentiométrique actionné par des aimants calés sur l'arbre de commande du contacteur.

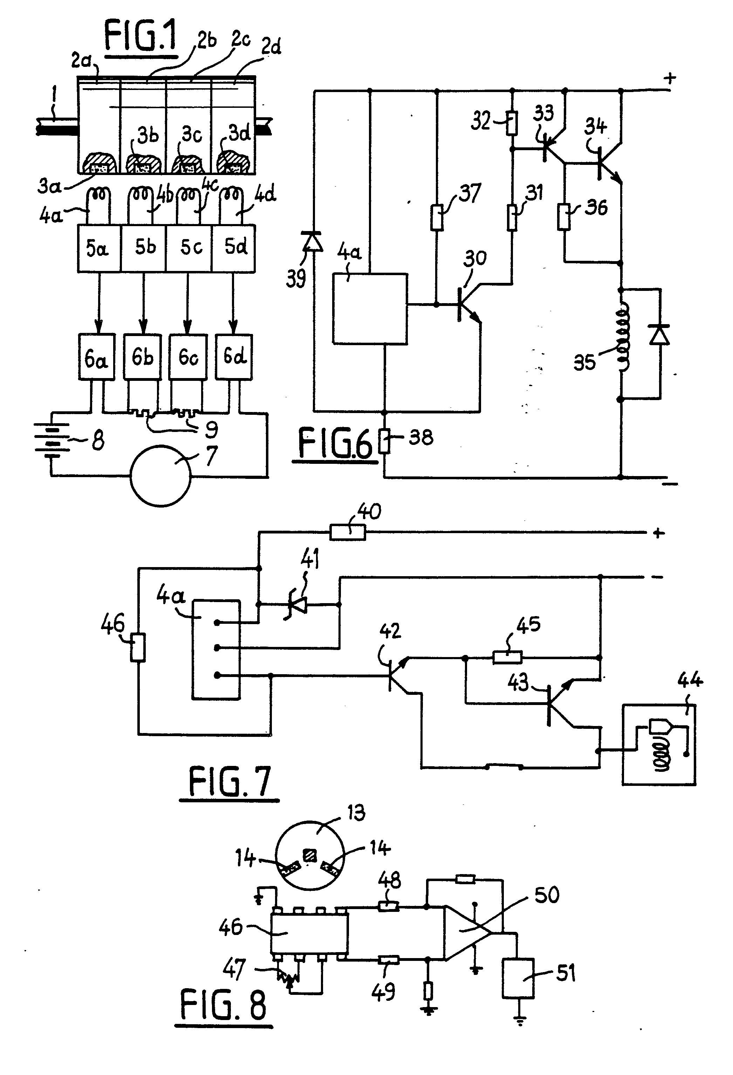

Le contacteur de commande représenté schématiquement à la Fig.1 comporte un arbre de commande rotatif 1 portant des supports 2a, 2b, 2c,2d dans lesquels sont montés des aimants 3a, 3b,3c,3d décalés angulairement ainsi qu'il sera expliqué par la suite. Les aimants 3a à 3d sont déplaçables devant les capteurs inductifs correspondants 4a à 4d connectés dans des circuits 5a à 5d de commande de relais 6a à 6d de modification du courant d'alimentation d'un moteur électrique d'entraînement 7 à courant continu alimenté par une batterie d'accumulateur 8.

La modification du courant d'alimentation du moteur 7 s'effectue de manière classique par exemple par la connexion ou la déconnexion dans le circuit d'alimentation dudit moteur de résistances de charge 9 correspondantes.

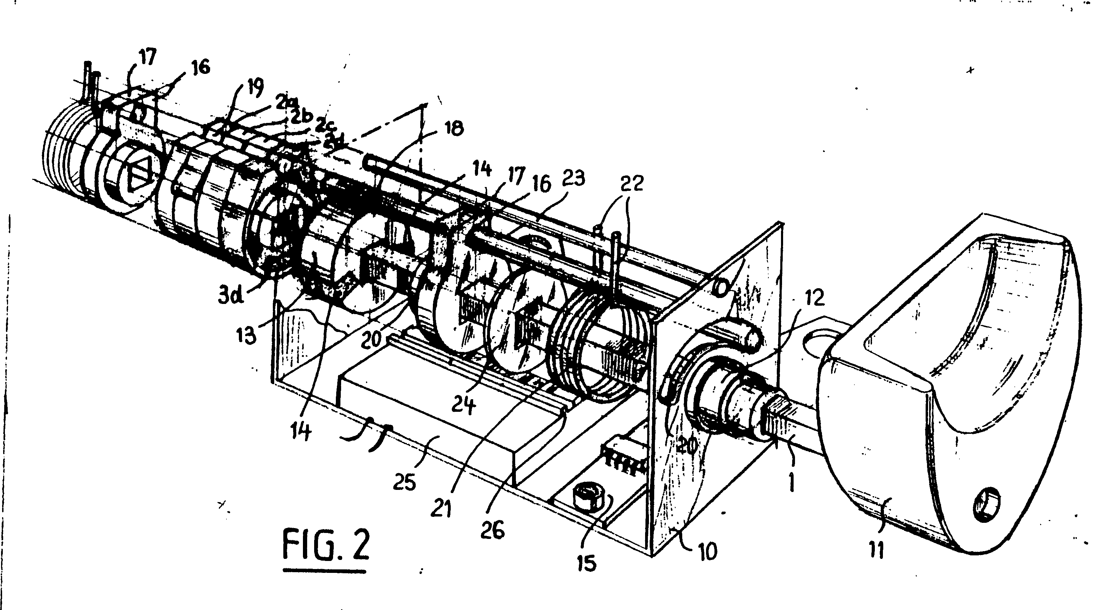

Le contacteur de commande représenté plus en détail à la Fig.2 comporte principalement un support métallique 10 dans les parois latérales duquel l'arbre de commande 1 pourvu de boutons d'actionnement tels que 11 fixés à ses deux extrémites, est monté à rotation par l'intermédiaire de paliers 12. L'arbre 1 est avantageusement réalisé de section carrée.

Sur l'arbre 1 sont montés des supports 2a à 2d des aimants permanents 3a à 3d ainsi qu'un support 13 portant deux aimants permanents 14 disposés symétriquement par rapport à la position de repos de l'arbre 1, destinés à actionner un dispositif potentiométrique 15 porté par le support 10.

Les supports 2a à 2d et 13 sont maintenus entre deux pièces de serrage 16 de forme générale circulaire également montées sur l'arbre 1 et qui comportent chacune une saillie 17 traversée par une tige d'assemblage 18 également engagée dans des gorges 19 des supports 2a à 2d pour assurer leur calage angulaire. Les extrémités de la tige d'assemblage 18 pénètrent dans des lumières curvilignes 20 concentriques à l'arbre de commande 1 et dont les extrémités forment butées pour la tige d'assemblage 18 et déterminent ainsi la course angulaire de l'arbre 1 de part et d'autre de sa position intermédiaire de repos.

Entre chacune des pièces 16 et le palier 12 correspondant de l'arbre 1, est monté un ressort de rappel 21 à plusieurs spires comportant des branches d'extrémité 22 qui s'étendent respectivement de part et d'autre de la tige d'assemblage 18 et qui prennent appui ur une tige fixe 23 solidaire du support 10. La tige 23 définit la position intermédiaire neutre de l'arbre de commande 1. Une rondelle 24 est interposée entre chaque ressort 21 et la pièce 16 correspondante.

Les supports d'aimant 2a à 2d sont montés sur l'arbre 1 de manière à se déplacer au-dessus d'un circuit intégré 25 porté par le support 10 et comportant les capteurs inductifs 4a à 4d représentés à la Fig.1 ainsi que les circuits de commande 5a à 5d associés.

Les supports d'aimant 2a à 2d présentent une forme générale circulaire à l'exception des régions dans lesquelles sont ménagées les gorges 19 destinées à coopérer avec la tige d'assemblage 18. Comme représenté à la Fig.5, les aimants 3a à 3d portés par les supports respectifs 2a à 2d sont des aimants curvilignes dont le positionnement angulaire et la longueur sont fonctions de la position angulaire de l'arbre de commande 1 pour laquelle chaque circuit de commande 5a à 5d doit intervenir pour modifier le courant d'alimentation du moteur d'entraînement 7 ainsi que de la course angulaire dudit arbre pendant laquelle cette intervention doit être maintenue.

On donne ci-après à titre d'exemple les étendues angulaires des aimants 3a à 3d.

Aimant 3a    125°
Aimant 3b    125°
Aimant 3c    70°
Aimant 3d    120°

La position de repos du contacteur est matérialisée sur la Fig.5 par l'axe de symétrie commun des supports 2a à 2d. Les aimants 3a à 3d s'étendent de part et d'autre de cet axe sur des angles de 20° et 105° pour l'aimant 3a, 105° et 20° pour l'aimant 3b, 35° et 35° pour l'aimant 3c, et 60° et 60° pour l'aimant 3d. Les aimants 3a et 3b assurent respectivement les commandes de marche avant et de marche arrière du chariot élévateur auquel est associé le contacteur. Les aimants 3c et 3d assurent l'augmentation du courant d'alimentation du moteur électrique du chariot en fonction de l'augmentation du déplacement angulaire dé l'arbre de commande 1 du contacteur dans un sens ou dans l'autre.

Les aimants 3a à 3d sont avantageusement réalisés à partir d'un barreau souple de matière plastique chargé de poudre magnétique.

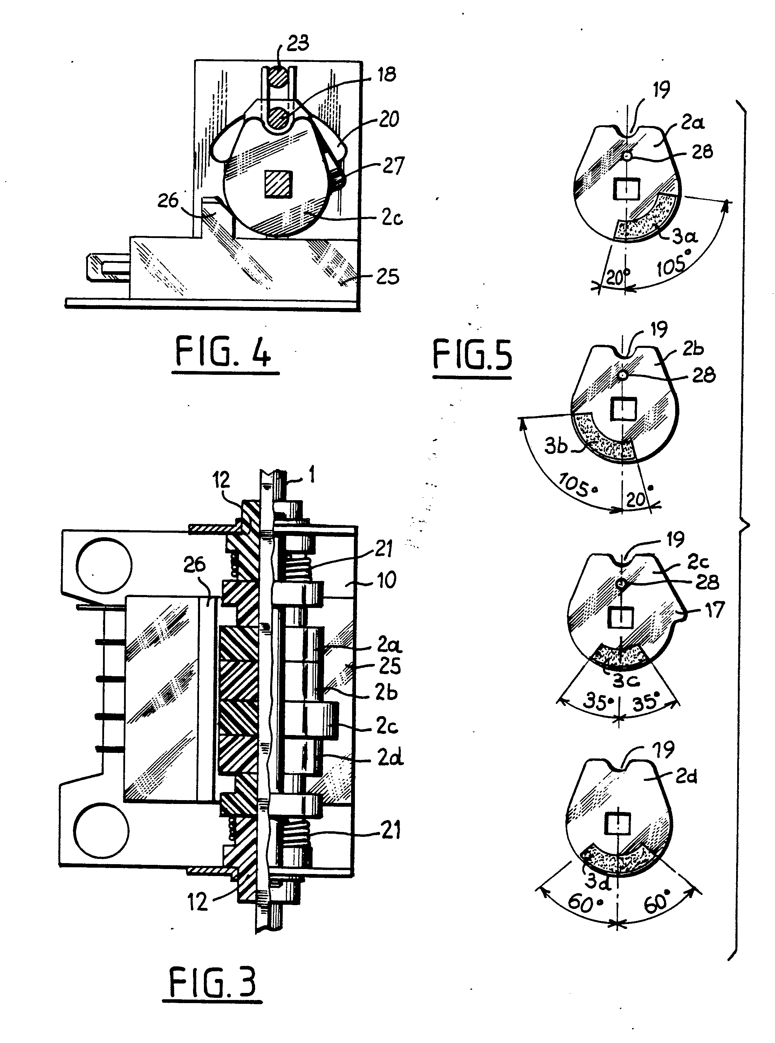

Le contacteur de commande représenté à la Fig.3 diffère de celui de la Fig.2 en ce qu'il ne comporte pas de moyen de commande de variateur électronique. Le circuit intégré 25 disposé au-dessous des supports 2a à 2d comporte sur sa face supérieure une nervure longitudinale 26 destinée à permettre le positionnement correct des supports d'aimant 2a à 2d par rapport au circuit intégré. Comme représenté notamment aux Fig.4 et 5 l'un des supports d'aimant, par exemple le support 2c présente une saillie latérale 27 dont l'encombrement est tel que ce support ne peut être monté en regard de la nervure 26 sans empêcher la rotation de l'ensemble. Cette saillie 27 permet d'assurer un montage correct du support d'aimant 2c par rapport au circuit intégré 25. Par ailleurs, les supports 2a à 2d comportent chacun un ergot 28 de positionnement, chaque ergot étant destiné a coopére avec un trou correspondant ménagé dans le support d'aimant voisin. La saillie 27 et les ergots 28 assurent donc d'une part un positionnement des supports d'aimant 2a à 2d les unes par rapport aux autres et d'autre part, le positionnement de l'ensemble desdits supports par rapport au circuit intégré 25.

Les capteurs inductifs 5a à 5d représentés au schéma de la Fig. 1 et qui font partie du circuit intégré 25 sont disposés respectivement à l'aplomb des aimants 3a à 3d. Ces capteurs sont des cellules qui sont au repos lorsque les aimants de commande qui leur sont associés se trouvent à leur proximité et qui sont rendues actives par l'absence d'excitation desdits aimants.

Un tel agencement permet d'assurer une sécurité du contacteur car il rend tout actionnement de celu-ci impossible par un aimant ou une pièce magnétique extérieure au contacteur.

Un exemple de circuit de montage d'un capteur inductif entrant dans la construction du contacteur de commande suivant l'invention est représenté à la Fig. 6.

Le capteur 4a qui est avantageusement un capteur à effet Hall est connecté par sa sortie à la base d'un transistor NPN 30 dont l'émetteur est relié à une autre borne du capteur 50 et dont le collecteur est connecté à deux résistances en série 31,32, la résistance 32 étant reliée à la borne positive du circuit. La jonction entre les résistances 31 et 32 est reliée à la base d'un transistor PNP 33 dont l'émetteur est relié à la borne positive du circuit et dont le collecteur est connecté à la base d'un transistor de puissance 34, le trajet collecteur-émetteur de celui-ci étant connecté en série avec l'enroule ment 35 d'un relais de puissance qui fait partie du circuit de commande de modification d'intensité 6a (Fig.1). La base du transistor de puissance 34 est connectée à son émetteur par l'intermédiaire d'une résistance 36. La base du transistor NPN 30 est reliée à la borne positive du circuit par l'intermédiaire d'une résistance 37. Le capteur à effet Hall 4a comporte une troisième borne connectée directement à la borne positive du circuit, tandis que la jonction entre le collecteur du transistor 30 et la deuxième borne du capteur 5a est reliée à la borne négative du circuit par l'intermédiaire d'une résistance 38. Enfin, une diode 39 est connectée aux bornes d'alimentation du capteur à effet Hall 4a.

Bien entendu, les autres capteurs inductifs du contacteur de commande suivant l'invention sont connectés dans des circuits identiques.

Le circuit représenté à la Fig. 7 est une variante du circuit de la Fig.6 destiné à fonctionner avec des signaux négatifs. Dans ce circuit, le capteur 4a est constitué par un capteur à effet Hall du type UGN 3020. Ses bornes d'alimentation sont connectées aux bornes positive et négative d'alimentation du circuit par l'intermédiaire d'une résistance 40, une diode Zener 41 assurant la limitation de la tension d'alimentation dudit capteur. La sortie du capteur 4a est connectée à la base d'un transistor NPN 42 de type PC 237 dont l'émetteur est connecté à la base d'un transistor de puissance 43 de type BUV 46. Le trajet émetteur-collecteur du transistor 43 est connecté entre la borne négative d'alimentation du circuit et un relais de puissance 44. Entre la base et l'émetteur du transistor de puissance 43 est connectée une résistance 45.

Enfin, entre la borne positive d'alimentation du capteur 4a et sa sortie, est connectée une résistance 46. Les résistances 40, 46 et 45 ont respectivement pour valeur 270 Ohms, 2,2 K et 4,7 K . La diode Zener 41 est de type EZX 15.

Le circuit de commande de variateur électronique associé au support 13 des aimants symétriques 14, est représenté à la Fig.8. Il s'agit d'un capteur à effet Hall 46 de type UGN 35,01 M auquel est associé un potentiomètre de réglage 47 et dont les sorties sont connectées par l'intermédiaire de résistance 48 et 49 aux entrées d'un amplificateur opérationnel 50 de type LM 324. La sortie de l'amplificateur est connectée à une charge, ici un relais 51 d'actionnement du variateur de vitesse.

Le contacteur de commande qui vient d'être décrit fonctionne de la façon suivante.

Lorsque l'arbre de commande 1 est en position de repos, les aimants 3a à 3d se trouvant en regard des capteurs inductifs 4a à 4d correspondants sont tous maintenus à l'état inactif. Le support 13 des aimants symétriques 14 associés au circuit 15 de commande du variateur électronique de vitesse représenté à la Fig.2 est dans une position telle que le capteur 46 de celui-ci n'est pas influencé par les aimants 14, de sorte que le circuit de commande du variateur de vitesse est également à l'état inactif.

Lorsque l'arbre de commande 1 est déplacé angulairement dans le sens de la marche avant, tant que l'aimant 3a porté par le support 2a se déplace devant le capteur 4a correspondant, celui-ci est maintenu à l'état inactif.

Lorsque l'aimant 3a quitte la proximité du capteur 4a, celui-ci est excité et par l'intermédiaire du circuit de commande 5a, provoque l'actionnement du relais correspondant du circuit 6a (Fig.1) et par conséquent l'alimentation du moteur électrique 7 d'entraînement du chariot élévateur.

L'aimant 3b porté par le support 2b qui présente la même étendue angulaire que l'aimant 3a mais qui s'étend par rapport à l'axe de symétrie des supports à l'opposé par rapport à l'aimant 3a, reste pendant toute la course de déplacement de l'arbre 1 dans le sens de la marche avant, à proximité du capteur inductif qui lui est associé, de sorte que celui-ci est maintenu inactif pendant toute la marche avant.

Lorsque l'arbre 1 est déplacé dans le sens de la marche avant de manière que l'aimant 3c porté par le support 2c quitte à son tour la proximité du capteur 4c correspondant, ce capteur est rendu actif à son tour et provoque par l'intermédiaire de son circuit de commande 5c, la mise en court-circuit de la résistance 9 du circuit d'alimentation du moteur 7 et par conséquent une augmentation du courant d'alimentation de celui-ci. Dans la portion finale de la course de l'arbre de commande 1 dans le sens de la march avant, l'aimant 3d quitte la proximité du capteur inductif 4b qui lui est associé et provoque à son tour la mise en court-circuit de la résistance chutrice 9 correspondante, ce qui permet d'obtenir un courant d'alimentation maximal du moteur électrique 7.

Le fonctionnement du contacteur de commande dans le sens de la march arrière est identique à celui de la march avant à l'exception du fait que c'est l'aimant 3b qui quitte la proximité de son capteur inductif 4b pour déclencher l'alimentation du moteur électrique 7 dans le sens de la marche arrière alors que l'aimant 3a reste en permanence à proximité de son capteur de sorte que la commande en march avant est rendue inactive.

Le dispositif de commande du variateur électronique de vitesse est réglé par exemple pour être rendu actif lorsque l'arbre de commande 1 attaque une position angulaire correspondante au début de l'actionnement du circuit associé à l'aimant 3c d'augmentation de la puissance d'alimentation du moteur électrique 7. A cet effet, les aimants 14 portés par le support 13 font entre eux un angle égal à l'angle que font entre elles les extrémités de l'aimant 3d.

Le potentiomète 47 permet d'assurer le réglage du circuit de commande 15 (Fig.2) en tenant compte de la course morte du premier aimant 3a ou 3b destiné à assurer avec son circuit de commande associé, le début de l'alimentation du moteur électrique 7 en march avant ou en marche arrière.

Le contacteur de commande qui vient d'être décrit présente vis à vis des contacteurs classiques un certain nombre d'avantages.

Il ne comporte aucun contact électrique susceptible de subir une usure.

Il n'y a aucun frottement entre les aimants d'excitation et les capteurs inductifs.

Il présente une grande souplesse de fonctionnement en raison de l'utilisation de circuit à transistors à la place d'interrupteurs électromécaniques.

## Revendications

1. Contacteur de commande notamment pour circuits d'alimentation d'un moteur électrique d'entraînement de chariot de manutention comprenant un support (10), un arbre de commande (1) monté à rotation dans les deux sens dans ledit support à l'aide de boutons de manoeuvre (11), pour commander le circuit d'alimentation du moteur électrique (7) d'entraînement du chariot de manière à déplacer le chariot soit en marche avant, soit en marche arrière, ledit arbre (1) étant pourvu de moyens d'actionnement successif d'organes de commande de la modification du courant d'alimentation du moteur électrique (7) d'entrainement en fonction de la position angulaire de l'arbre, caractérisé en ce que lesdits moyens d'actionnement successif sont constitués par des aimants (3a à 3d) montés dans des supports (2a à 2d) solidaires de l'arbre de commande (1) et décalés angulairement les uns par rapport aux autres, tandis que les organes de commande de la modification du courant d'alimentation comprennent des capteurs inductifs (4a à 4d) associés aux aimants correspondants.

2. Contacteur suivant la revendication 1, caractérisé en ce que les aimants (3a à 3d) sont des aimants curvilignes décalés angulairement les uns par rapport aux autres, l'étendue angulaire de chaque aimant correspondant à la portion de la course angulaire de l'arbre de commande (1) a l'issue de laquelle l'intervention du capteur inductif (4a à 4d) qui lui est associé doit avoir lieu.

3. Contacteur suivant l'une des revendications 1 et 2, caractérisé en ce que les capteurs inductifs (4a à 4d) sont des capteurs à effet Hall connectés pour être rendus actifs en l'absence d'excitation par les aimants (3a à 3d) correspondants.

4. Contacteur suivant l'une des revendications 1 à 3, caractérisé en ce que les supports (2a à 2d) desdits aimants (3a à 3d) comportent chacun un ergot de positionnement (28) coopérant avec un trou ménagé dans le support voisin.

5. Contacteur suivant l'une quelconque des revendications 1 à 4, caractérisé en ce que les capteurs inductifs (4a à 4d) font partie d'un circuit intégré (25) porté par le support (10) du contacteur, au moins l'un des supports d'aimants (2c) comportant une saillie latérale (27) de positionnement correct de l'ensemble des supports d'aimants par rapport au circuit intégré (25), celui-ci comportant une une nervure (26) disposée de façon à empêcher la rotation des supports d'aimants (2a à 2d) par rapport audit circuit intégré si la saillie latérale (27) est montée en regard de ladite saillie.

6. Contacteur suivant l'une des revendications 1 à 5, caractérisé en ce qu'il comporte en outre monté sur l'arbre de commande (1) un support (13) pour des aimants (14) disposés symétriquement par rapport à la position de repos de l'arbre de commande (1) et destinés à commander un dispositif potentiométrique (15) d'actionnement d'un variateur électronique de vitesse pour le moteur électrique (7) d'entraînement du chariot, le dispositif potentiométrique étant porté par le support (10).

7. Contacteur suivant l'une des revendications 1 à 5, caractérisé en ce que chaque capteur à effet Hall (4a à 4d) est connecté dans un circuit (30, 33,34;42,43) de commande d'un relais de puissance (35;44) qui fait partie de moyens de modification du courant d'alimentation dudit moteur électrique (7), ledit circuit de commande (30,33,34; 42, 43) faisant partie dudit circuit intégré (25).

8. Capteur suivant l'une des revendications 6 et 7, caractérisé en ce que le dispositif potentiométrique (15) comporte un capteur à effet Hall (46) à la sortie duquel est connecté un amplificateur opérationnel (50), un potentiomètre (47) de réglage du zéro dudit capteur à effet Hall (46) en fonction de la positon angulaire de l'arbre de commande (1) à laquelle le dispositif potentiométrique (15) doit intervenir pour commander le variateur électronique de vitesse, étant associé audit capteur à effet Hall (46).

FIG.1

FIG.6

FIG.7

FIG.8

FIG. 2

FIG. 4

FIG.5

FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A-2 251 944 (SOCIETE INDUSTRIELLE FENWICK-MANUTENTION) * Figure 3 * | 1 | H 03 K 17/97 |
| A | US-A-2 472 646 (C.E. COCHRAN) | | |
| A | DE-A-3 333 497 (VDO A. SCHINDLING AG) * Page 2, lignes 31-36 * | 1 | |
| A | US-A-3 201 533 (E.H. FREDRICKSON) | | |
| A | US-A-4 054 860 (D.M. HENDERSON et al.) | | |
| A | US-A-4 489 303 (TH.B. MARTIN) | | |
| A | US-A-4 639 667 (H.J. ANDERSON) * Figure 4; résumé * | 1 | |
| E,X | FR-A-2 601 206 (G. HARDELLET) * En entier * | 1-8 | |

**DOMAINES TECHNIQUES RECHERCHES (Int. Cl.4)**

H 03 K
H 02 P
H 01 H
B 60 L

Le présent rapport a été établi pour toutes les revendications

| Lieu de la recherche | Date d'achèvement de la recherche | Examinateur |
|---|---|---|
| LA HAYE | 01-08-1988 | BEYER F. |